(19) Europäisches Patentamt
European Patent Office
Office européen des brevets

(11) **EP 4 563 553 A1**

(12) **EUROPÄISCHE PATENTANMELDUNG**

(43) Veröffentlichungstag:
**04.06.2025 Patentblatt 2025/23**

(21) Anmeldenummer: 23213376.9

(22) Anmeldetag: **30.11.2023**

(51) Internationale Patentklassifikation (IPC):
**C04B 37/02** (2006.01)      **C04B 41/53** (2006.01)
**H01L 21/306** (2006.01)      **C04B 41/00** (2006.01)

(52) Gemeinsame Patentklassifikation (CPC):
**C04B 37/026; C04B 41/009; C04B 41/5346;**
**C04B 41/5353;** C04B 2237/127; C04B 2237/368;
C04B 2237/402; C04B 2237/407

(84) Benannte Vertragsstaaten:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Benannte Erstreckungsstaaten:
**BA**
Benannte Validierungsstaaten:
**KH MA MD TN**

(71) Anmelder: **Heraeus Electronics GmbH & Co. KG**
**63450 Hanau (DE)**

(72) Erfinder:
• **Wacker, Richard**
  **63450 Hanau (DE)**
• **Niewolak, Leszek**
  **63450 Hanau (DE)**
• **Stoica, Stefanie**
  **63450 Hanau (DE)**
• **Schauer, Carsten**
  **63450 Hanau (DE)**

(74) Vertreter: **Heraeus IP**
**Heraeus Business Solutions GmbH**
**Intellectual Property**
**Heraeusstraße 12-14**
**63450 Hanau (DE)**

(54) **METALL-KERAMIK-VERBUND**

(57)     Die vorliegende Erfindung betrifft einen Metall-Keramik-Verbund, enthaltend

ein Keramiksubstrat, das eine Vorderseite und eine Rückseite aufweist und Siliziumnitrid enthält,

eine auf der Vorderseite des Keramiksubstrats vorliegende Metallbeschichtung,

wobei

die Metallbeschichtung zumindest eine Aussparung aufweist und eine Oberfläche des Keramiksubstrats durch die Aussparung freigelegt ist,

das Keramiksubstrat zumindest in dem Bereich der Aussparung in einem durch Röntgenphotoelektronenspektroskopie aufgenommen Energiespektrum (nachfolgend auch als XPS-Spektrum bezeichnet) im Bereich von 96 bis 107 eV ein Si2p-Signal zeigt,

wobei das Si2p-Signal Folgendes aufweist:

einen oder mehrere Peaks, die jeweils ein Maximum im Bereich von 98,0 bis 100,0 eV aufweisen,

einen oder mehrere Peaks, die jeweils ein Maximum im Bereich von 101,0 bis 102,2 eV aufweisen,

einen oder mehrere Peaks, die jeweils ein Maximum im Bereich von 102,5 bis 104,0 eV aufweisen.

EP 4 563 553 A1

**Beschreibung**

Die vorliegende Erfindung betrifft einen Metall-Keramik-Verbund, der als keramischer Schaltungsträger in der Leistungselektronik verwendbar ist.

In der Leistungselektronik müssen Leiterplatten als Träger von Leistungsbauteilen wie MOSFETs für hohe Ströme ausgelegt sein und Verlustwärme schnell abführen können.

Da keramische Materialien wie Aluminiumoxid, Aluminiumnitrid und Siliziumnitrid gegenüber Polymeren, die für die Herstellung herkömmlicher Leiterplatten verwendet werden, eine wesentlich höhere Wärmeleitfähigkeit aufweisen, werden in Leistungsmodulen häufig keramische Schaltungsträger verwendet.

Keramiksubstrate auf der Basis von Siliziumnitrid weisen eine sehr hohe mechanische Festigkeit bei gleichzeitig hoher Wärmeleitfähigkeit auf und sind daher sehr gut für Anwendungen in der Leistungselektronik geeignet.

Keramiksubstrate auf der Basis von Siliziumnitrid werden beispielsweise in folgenden Publikationen beschrieben:

N. Chasserio et al., "Ceramic Substrates for High-Temperature Electronic Integration", Journal of Electronic Materials, Band 38 (2009), S. 164-174;
K. Hirao et al., "High Thermal Conductivity Silicon Nitride Ceramics", Journal of the Korean Ceramic Society, Band 49 (2012), S. 380-384;
Y. Zhou et al., "Development of high-thermal-conductivity silicon nitride ceramics", Journal of Asian Ceramic Societies, 3 (2015), S. 221-229.

Siliziumnitridbasierte Keramiksubstrate, die einen guten Kompromiss zwischen hoher mechanischer Festigkeit und hoher Wärmeleitfähigkeit zeigen und in elektronischen Bauteilen verwendet werden können, sind kommerziell erhältlich.

Ein keramischer Schaltungsträger enthält ein Keramiksubstrat, das zumindest auf einer seiner Seiten, üblicherweise beidseitig mit einer Metallschicht versehen ist. Auf einer dieser Metallschichten sind im finalen Modul die Halbleiterbauelemente aufgebracht, während die Metallschicht auf der gegenüberliegenden Seite des Keramiksubstrats thermisch leitend mit einem Kühlkörper verbunden ist. Durch das Keramiksubstrat sind die Metallschichten elektrisch isoliert voneinander.

Die dem Fachmann bekannte Herstellung eines als keramische Leiterplatte fungierenden metallisierten Keramiksubstrats erfolgt beispielsweise, indem die Vorder- und Rückseite des Keramiksubstrats jeweils mit einer Metallfolie (z.B. einer Kupfer- oder Aluminiumfolie) in Kontakt gebracht und stoffschlüssig verbunden werden. Das stoffschlüssige Verbinden der Metallfolien erfolgt beispielsweise über ein eutektisches Bonden oder ein Aktivlöten (englisch: *"active metal brazing"*, AMB). Ist die Metallfolie eine Kupferfolie, so wird das eutektische Bonding auch als DCB- oder DBC-Verfahren bezeichnet (DCB: *"Direct Copper Bonding"*; DBC: *"Direct Bonded Copper"*). Im Fall einer Aluminiumfolie wird beim eutektischen Bonding auch die Bezeichnung "DAB" (*"Direct Aluminum Bonding")* verwendet. Ein über ein DCB- oder AMB-Verfahren hergestelltes metallisiertes Keramiksubstrat wird gelegentlich auch als DCB-Substrat (alternativ: DBC-Substrat) oder AMB-Substrat bezeichnet.

Die Metallisierung von Siliziumnitridsubstraten erfolgt üblicherweise durch ein Aktivlöten.

Aktivlote enthalten neben einer Hauptkomponente wie z.B. Cu, Ag oder Au ein oder mehrere Elemente, die mit der Keramik unter Ausbildung einer haftvermittelnden Reaktionsschicht reagieren können (siehe z.B. Kapitel 8.2.4.3 ("Aktivlöten"), Seiten 203-204, in Brevier Technische Keramik, Verband der Keramischen Industrie e.V., 2003, Fahner Verlag). Als reaktive Elemente kommen beispielsweise Hafnium (Hf), Titan (Ti), Zirkonium (Zr), Niob (Nb), Cer (Ce), Tantal (Ta) und Vanadium (V) zum Einsatz. Bei der Metallisierung von Siliziumnitridsubstraten durch Aktivlöten enthält die Reaktionsschicht beispielsweise ein Nitrid, Oxynitrid und/oder Silicid des reaktiven Elements (A. Pönicke et al., "Aktivlöten von Kupfer mit Aluminiumnitrid- und Siliziumnitridkeramik", Keramische Zeitschrift, 63(5), 2011, 334-342).

Die die Halbleiterbauelemente tragende Metallschicht weist eine oder mehrere Aussparungen auf und wird daher auch als strukturierte Metallbeschichtung bezeichnet. Durch die Strukturierung werden beispielsweise metallische Leiterbahnen auf dem Keramiksubstrat ausgebildet. Benachbarte Leiterbahnen sind durch die Aussparungen räumlich getrennt und und daher elektrisch voneinander isoliert. Die Strukturierung von AMB-Substraten kann beispielsweise in einem zweistufigen Verfahren erfolgen, wobei in einem ersten Schritt in definierten Bereichen zunächst die Metallschicht abgetragen wird (z.B. unter Verwendung einer ersten Ätzlösung) und anschließend in einem zweiten Schritt die aus dem Aktivlotverfahren resultierende Haftvermittlungsschicht entfernt wird (z.B. unter Verwendung einer zweiten Ätzlösung). Durch das Abtragen der Metallschicht und gegebenenfalls der Haftvermittlungsschicht wird das Keramiksubstrat in definierten Bereichen wieder freigelegt.

In der Leistungselektronik verwendete Module auf der Basis keramischer Schaltungsträger können im Rahmen des "Packaging" beispielsweise verkapselt werden, indem das Leistungsmodul in eine Vergussmasse eingebettet wird.

Durch die Einbettung in eine Vergussmasse wird beispielsweise die elektrische Durchschlagsfestigkeit erhöht.

Außerdem werden die Halbleiterbauelemente und metallischen Leiterbahnen vor Luftfeuchtigkeit geschützt und mechanisch stabilisiert.

In den durch die Strukturierung freigelegten Bereichen kommt das Keramiksubstrat in direkten Kontakt mit der Vergussmasse. Beim Betrieb eines Leistungsmoduls können erhebliche Temperaturschwankungen auftreten. Da keramische Materialien und die Vergussmasse üblicherweise deutlich unterschiedliche Wärmeausdehnungskoeffizienten aufweisen, führen diese Temperaturschwankungen zu mechanischen Spannungen an der Grenzfläche zwischen Keramik und Vergussmasse. Dies wiederum kann dazu führen, dass die Vergussmasse sich zumindest teilweise von dem Keramiksubstrat ablöst und Hohlräume entstehen. Luftfeuchtigkeit, die in diese Hohlräume eindringt, kann das Leistungsmodul schädigen. Außerdem kann es zumindest lokal zu einer signifikanten Reduzierung der elektrischen Durchschlagsfestigkeit kommen. Problematisch ist insbesondere, wenn sich Feuchtigkeit in einer der Aussparungen der Metallbeschichtung, durch die die benachbarten Leiterbahnen oder Chipträgerbereiche voneinander getrennt sind, niederschlägt.

Wie oben bereits erwähnt, werden Keramiksubstrate auf der Basis von Siliziumnitrid aufgrund ihrer sehr hohen mechanischen Festigkeit bei gleichzeitig hoher Wärmeleitfähigkeit als Schaltungsträger in der Leistungselektronik verwendet. Um ihr Potential als Schaltungsträger möglichst umfassend zu nutzen, wäre es wünschenswert, dass nach einer Einbettung in eine Vergussmasse eine hohe Haftfestigkeit zwischen dieser Vergussmasse und der Siliziumnitridoberfläche vorliegt.

Eine Aufgabe der vorliegenden Erfindung ist die Bereitstellung eines metallisierten siliziumnitridhaltigen Keramiksubstrats, das einen verbesserten Feuchtigkeitsschutz aufweist. Insbesondere sollte der Feuchtigkeitsschutz auch dann noch gegeben sein, wenn sich die Vergussmasse im Bereich einer Aussparung der Metallbeschichtung von der Keramikoberfläche ablöst.

Gelöst wird diese Aufgabe durch einen Metall-Keramik-Verbund, enthaltend

ein Keramiksubstrat, das eine Vorderseite und eine Rückseite aufweist und Siliziumnitrid enthält,
eine auf der Vorderseite des Keramiksubstrats vorliegende Metallbeschichtung, wobei
die Metallbeschichtung zumindest eine Aussparung aufweist und eine Oberfläche des Keramiksubstrats durch die Aussparung freigelegt ist,
das Keramiksubstrat zumindest in dem Bereich der Aussparung in einem durch Röntgenphotoelektronenspektroskopie aufgenommen Energiespektrum (nachfolgend auch als XPS-Spektrum bezeichnet) im Bereich von 96 bis 107 eV ein Si2p-Signal zeigt,
wobei das Si2p-Signal Folgendes aufweist:

einen oder mehrere Peaks, die jeweils ein Maximum im Bereich von 98,0 bis 100,0 eV aufweisen,
einen oder mehrere Peaks, die jeweils ein Maximum im Bereich von 101,0 bis 102,2 eV aufweisen,
einen oder mehrere Peaks, die jeweils ein Maximum im Bereich von 102,5 bis 104,0 eV aufweisen.

Das Signal eines Elements im XPS-Spektrum wird durch seinen Oxidationszustand und seine chemische Umgebung (z.B. seine chemischen Bindungspartner) beeinflusst. Wenn also beispielsweise die in einem Keramiksubstrat vorliegenden Si-Atome einen einheitlichen Oxidationszustand und jeweils eine übereinstimmende chemische Umgebung aufweisen, ist im XPS-Spektrum ein Si2p-Signal mit relativ enger Halbwertsbreite zu erwarten. Für übliche siliziumnitridbasierte Keramiksubstrate trifft dies zu. Auch nach Kontakt mit einem Ätzmedium, beispielsweise beim Abtragen einer auf dem Siliziumnitrid vorliegenden Metallbeschichtung, zeigt das XPS-Spektrum üblicherweise ein Si2p-Signal geringer Halbwertsbreite.

Im Rahmen der vorliegenden Erfindung wurde erkannt, dass die Behandlung des Keramiksubstrats mit einem Ultrakurzpulslaser zu einer deutlichen Erhöhung der Hydrophobizität der behandelten Siliziumnitridoberfläche führen kann. Dies zeigt sich beispielsweise an einer deutlichen Erhöhung des Benetzungswinkels für Wasser im Vergleich zu einer unbehandelten oder mit einem Ätzmedium kontaktierten Siliziumnitridkeramik. Dies führt zu einem verbesserten Feuchtigkeitsschutz der Siliziumnitridkeramik.

Weiterhin wurde im Rahmen der vorliegenden Erfindung erkannt, dass sich im Si2p-Signal des XPS-Spektrums der durch die Laserbehandlung hydrophobisierten Siliziumnitridoberfläche zusätzliche Peaks zeigen, die im Si2p-Signal der unbehandelten oder mit einem Ätzmedium behandelten Siliziumnitridkeramik nicht vorliegen.

In den XPS-Spektren der unbehandelten und der mit einem Ätzmedium kontaktierten Siliziumnitridkeramik zeigt das Si2p-Signal im Wesentlichen nur einen Peak, dessen Maximum im Bereich von 101,0 bis 102,2 eV liegt. In den XPS-Spektren der Siliziumnitridkeramiken, die mit einem gepulsten Laser behandelt wurden und als Resultat dieser Behandlung einen deutlich höheren Wasserbenetzungswinkel aufweisen, zeigen sich im Si2p-Signal weitere Peaks, deren Maxima im Bereich von 98,0 bis 100,0 eV und im Bereich von 102,5 bis 104,0 eV liegen.

Beispielsweise liegen in den Bereichen von 98,0 bis 100,0 eV, 101,0 bis 102,2 eV und 102,5 bis 104,0 eV jeweils mindestens ein Peak, jedoch nicht mehr als zwei Peaks vor, deren Maximum in dem jeweiligen Bereich liegt.

In einer weiteren beispielhaften Ausführungsform liegt in den Bereichen von 98,0 bis 100,0 eV, 101,0 bis 102,2 eV und 102,5 bis 104,0 eV jeweils nur ein einziger Peak vor, dessen Maximum in dem jeweiligen Bereich liegt.

In einer beispielhaften Ausführungsform gilt Folgendes:

$$I_1 / I_{ges} \geq 0,02;$$

$$2,0 \leq I_2 / I_1 \leq 8,0; \text{ unter der Maßgabe, dass } (I_1 + I_2) / I_{ges} \leq 0,85;$$

$$(I_1 + I_2 + I_3) / I_{ges} \geq 0,95;$$

wobei

$I_{ges}$ die Gesamtintensität des Si2p-Signals ist;
$I_1$ die Gesamtintensität der Peaks ist, deren Maximum jeweils im Bereich von 98,0-100,0 eV liegt;
$I_2$ die Gesamtintensität der Peaks ist, deren Maximum jeweils im Bereich von 101,0-102,2 eV liegt;
$I_3$ die Gesamtintensität der Peaks ist, deren Maximum jeweils im Bereich von 102,5-104,0 eV liegt.

Die Gesamtintensität $I_{ges}$ des Si2p-Signals ergibt sich aus der Summe der Intensitäten aller Peaks, aus denen sich das Si2p-Signal zusammensetzt.

Die Intensität eines Peaks ist die Fläche unter diesem Peak.

Liegt nur ein Peak vor, der ein Maximum in dem Bereich von 98,0 bis 100,0 eV des Si2p-Signals aufweist, so entspricht die Gesamtintensität $I_1$ der Intensität dieses Peaks. Liegen insgesamt zwei Peaks vor, die jeweils ein Maximum in dem Bereich von 98,0 bis 100,0 eV aufweisen, so entspricht die Gesamtintensität $I_1$ der Summe der beiden Peakintensitäten. Auf die gleiche Weise werden in den Bereichen von 101,0 bis 102,2 eV und 102,5 bis 104,0 eV die Gesamtintensitäten $I_2$ und $I_3$ bestimmt.

Beispielsweise gilt Folgendes:

$$I_1 / I_{ges} \geq 0,05;$$

$$2,5 \leq I_2 / I_1 \leq 7,0 \text{ unter der Maßgabe, dass } (I_1 + I_2) / I_{ges} \leq 0,80;$$

$$(I_1 + I_2 + I_3) / I_{ges} \geq 0,95.$$

In einer weiteren beispielhaften Ausführungsform gilt Folgendes:

$$2,0 \leq I_2 / I_1 \leq 8,0$$

$$0,40 \leq (I_1 + I_2) / I_{ges} \leq 0,85;$$

$$(I_1 + I_2 + I_3) / I_{ges} \geq 0,95$$

Beispielsweise gilt Folgendes:

$$2,5 \leq I_2 / I_1 \leq 7,0$$

$$0,50 \leq (I_1 + I_2) / I_{ges} \leq 0,80;$$

$$(I_1 + I_2 + I_3) / I_{ges} \geq 0,95$$

In einer weiteren beispielhaften Ausführungsform gilt Folgendes:

$$0{,}05 \leq l_1 / l_{ges} \leq 0{,}20$$

$$0{,}20 \leq l_2 / l_{ges} \leq 0{,}70;$$

$$(l_1 + l_2 + l_3) / l_{ges} \geq 0{,}95.$$

Beispielsweise enthält das Keramiksubstrat das Siliziumnitrid in einem Anteil von mindestens 70 Gew%, bevorzugter mindestens 80 Gew%.

Das Siliziumnitrid liegt beispielsweise in der β-Phase (β-Siliziumnitrid) vor.

Optional kann das Keramiksubstrat noch ein oder mehrere Metalloxide enthalten. Diese wurden beispielsweise während der Herstellung des Keramiksubstrats als Sinterhilfsmittel zugegeben. Beispielsweise enthält das Keramiksubstrat eines oder mehrere der folgenden Oxide: Ein oder mehrere Erdalkalimetalloxide wie z.B. Magnesiumoxid, ein oder mehrere Übergangsmetalloxide (z.B. ein oder mehrere Seltenerdoxide wie Yttriumoxid oder Erbiumoxid), ein Siliziumoxid (z.B. $SiO_2$) oder ein Silikat.

Das Keramiksubstrat weist beispielsweise eine Dicke im Bereich von 0,1 mm bis 1,0 mm auf.

Auf der Vorderseite des Keramiksubstrats liegt eine Metallbeschichtung vor, die zumindest eine Aussparung aufweist, so dass eine Oberfläche des Keramiksubstrats durch die Aussparung freigelegt ist. Diese Metallbeschichtung wird nachfolgend auch als strukturierte Metallbeschichtung bezeichnet. Auf der strukturierten Metallbeschichtung können die Halbleiterbauelemente angebracht werden.

Optional liegt auf der Rückseite des Keramiksubstrats ebenfalls eine Metallbeschichtung vor. Diese rückseitige Metallbeschichtung kann optional ebenfalls zumindest eine Aussparung, durch die eine Oberfläche des Keramiksubstrats freigelegt ist, aufweisen. Um eine möglichst effiziente Wärmeabführung zu erzielen, kann es bevorzugt sein, dass die rückseitige Metallbeschichtung keine solche Aussparung aufweist.

Die auf der Vorderseite und optional der Rückseite des Keramiksubstrats vorliegende Metallbeschichtung ist beispielsweise eine Kupferbeschichtung oder eine Aluminiumbeschichtung. Die Metallbeschichtung weist beispielsweise eine Dicke im Bereich von 0,05 mm bis 1,5 mm, bevorzugter 0,2 mm bis 0,8 mm auf.

Sofern die Metallbeschichtung eine Kupferbeschichtung ist, weist diese beispielsweise einen Kupfergehalt von mindestens 97 Gew%, bevorzugter mindestens 99 Gew% auf.

Sofern die Metallbeschichtung eine Aluminiumbeschichtung ist, weist diese beispielsweise einen Aluminiumgehalt von mindestens 97 Gew%, bevorzugter mindestens 99 Gew% auf.

Die Metallbeschichtung kann über Verfahren, die dem Fachmann bekannt sind, auf die Vorderseite und gegebenenfalls die Rückseite des Keramiksubstrats aufgebracht werden.

Beispielsweise wird eine Metallfolie (z.B. eine Kupfer- oder Aluminiumfolie) durch ein Aktivlöten, stoffschlüssig mit der Vorderseite des Keramiksubstrats verbunden.

Beim Aktivlöten wird beispielsweise bei einer Temperatur von etwa 600-1000°C eine Verbindung zwischen der Metallfolie und dem Keramiksubstrat unter Verwendung eines Aktivlots hergestellt. Aktivlote sind aufgrund ihrer Legierungszusammensetzung in der Lage, nichtmetallische, anorganische Werkstoffe wie z.B. Keramiksubstrate zu benetzen. Neben einer Hauptkomponente wie z.B. Kupfer, Silber und/oder Gold enthalten Aktivlote auch ein oder mehrere Aktivmetalle wie z.B. Hf, Ti, Zr, Nb, V, Ta oder Ce, die mit dem Keramiksubstrat unter Ausbildung einer Reaktionsschicht reagieren können.

Bevorzugt liegt zwischen der Metallbeschichtung und der Vorderseite des Keramiksubstrats eine aus dem Aktivlöten resultierende Reaktionsschicht vor. Die Reaktionsschicht enthält beispielsweise ein oder mehrere Elemente $E_{RS}$, ausgewählt aus Hf, Ti, Zr, Nb, V, Ta und Ce, bevorzugt ausgewählt aus Hf, Ti, Zr, Nb und Ce, bevorzugter ausgewählt aus Hf, Ti und Zr. Besonders bevorzugt ist das Element $E_{RS}$ in der Reaktionsschicht Titan. Beispielsweise liegen die Elemente $E_{RS}$ in der Reaktionsschicht in Form eines Nitrids, Oxynitrids und/oder Silicids vor. Beispielsweise enthält die Reaktionsschicht die Elemente $E_{RS}$ in einer Gesamtmenge von mindestens 50 Gew%. Beispielsweise enthält die Reaktionsschicht die Nitride, Oxynitride und Silicide der Elemente ESR in einer Gesamtmenge von mindestens 70 Gew%, bevorzugter mindestens 85 Gew%. In einem Halbleitermodul der Leistungselektronik kann die Migration von Silber zu Problemen führen. Es kann daher bevorzugt sein, dass die Reaktionsschicht Silber in einem Anteil von nicht mehr als 5 Gew%, bevorzugter nicht mehr als 1 Gew% enthält oder sogar silberfrei ist.

Das Freilegen einer Oberfläche des Keramiksubstrats erfolgt beispielsweise in mehreren Schritten. Zunächst wird beispielsweise durch ein Ätzen die Metallbeschichtung abgetragen und die beim Aktivlöten gebildete Reaktionsschicht freigelegt. Anschließend wird die freigelegte Reaktionsschicht abgetragen, z.B. durch ein Ätzen oder eine Laserablation. Bevorzugt wird die freigelegte Reaktionsschicht unter Verwendung eines Ultrakurzpulslasers (z.B. eines IR-Picosekunden- oder Femtosekundenlasers) entfernt.

Um die durch die Aussparung voneinander getrennten Bereiche der Metallbeschichtung elektrisch voneinander zu isolieren, wäre es ausreichend, die Materialabtragung mit dem Pulslaser nur solange bzw. unter solchen Bedingungen durchzuführen, bis in den behandelten Bereichen das elektrisch leitfähige Material vollständig entfernt wurde, eine Modifikation des Siliziumnitrids an der Oberfläche des Keramiksubstrats aber vermieden wird.

Im Rahmen der vorliegenden Erfindung erfolgt jedoch durch die Behandlung mit dem Pulslaser nicht nur ein Freilegen der Keramiksubstratoberfläche, sondern auch eine Modifikation des Siliziumnitrids an der Oberfläche des Keramiksubstrats. Als Ergebnis dieser Modifizierung zeigt das Keramiksubstrat zumindest in dem Bereich der Aussparung ein Si2p-Signal im XPS-Spektrum, das zusätzliche Peaks aufweist, deren Maxima im Bereich von 98,0 bis 100,0 eV und 102,5 bis 104,0 eV liegen. Für die Herstellung eines Metall-Keramik-Substrats, das das erfindungsgemäße Si2p-Signal im XPS-Spektrum aufweist, hat es sich als vorteilhaft erwiesen, wenn die Pulse des Laserstrahls eine Energiedichte von mindestens 2 J/cm$^2$ aufweisen. Die Pulsfrequenz des Laserstrahl beträgt beispielsweise 1000 kHz.

Im Rahmen der vorliegenden Erfindung ist es auch möglich, die Keramiksubstratoberfläche zunächst durch einen ein- oder mehrstufigen Ätzprozess freizulegen und anschließend die freigelegte Keramiksubstratoberfläche mit dem gepulsten Laserstrahl zu behandeln, bis das erfindungsgemäße Si2p-Signal im XPS-Spektrum verwirklicht ist.

Aus Gründen der Verfahrenseffizienz kann es jedoch bevorzugt sein, den Pulslaser sowohl für die Freilegung der Keramiksubstratoberfläche als auch die Modifikation des Siliziumnitrids an der Oberfläche des Keramiksubstrats zu nutzen.

Eine freigelegte Oberfläche des Keramiksubstrats, die im XPS-Spektrum das erfindungsgemäße Si2p-Signal aufweist, zeigt einen höheren Wasserbenetzungswinkel. Dies führt zu einem besseren Feuchtigkeitsschutz des Metall-Keramik-Verbunds.

Die vorliegende Erfindung betrifft außerdem ein Halbleitermodul, enthaltend

den oben beschriebenen Metall-Keramik-Verbund,
ein oder mehrere Halbleiterbauelemente.

Bevorzugt enthält das Halbleitermodul eine Vergussmasse, wobei die Vergussmasse die durch die Aussparung freigelegte Oberfläche des Keramiksubstrats des Metall-Keramik-Verbunds kontaktiert.

Vergussmassen für elektronische Bauelemente sind dem Fachmann bekannt. Die Vergussmasse enthält beispielsweise ein Polymer (z.B. ein thermoplastisches oder duroplastisches Polymer). Beispielsweise enthält die Vergussmasse ein optional ausgehärtetes Epoxidharz oder Silikonharz, ein Polyurethan oder einen anorganischen Zement (z.B. einen Phosphatzement).

**Messmethoden**

Messung der XPS-Spektren

Die Aufnahme und Auswertung der XPS-Energiespektren erfolgte folgendermaßen:
Zur Vorbereitung der Messungen mittels Röntgenphotoelektronenspektroskopie wurden die Keramik-Proben mit den Kantenlängen 2 (+/- 0,1) cm x 2 (+/- 0,1) cm so zerteilt, dass die die exponierten $Si_3N_4$-Keramikbereiche erhalten wurden. Die Reinigung der Probenstücke von Staub erfolgte durch Abpusten mit Stickstoffgas. Die Probenstücke wurden mittels nichtleitendem Klebeband auf einen Probenhalter geklebt. Die Aufnahme der Röntgenphotoelektronenspektren erfolgte an einem PHI 5800 ESCA von Physical Electronics mit einer Mg-Anode (monochromatische K$\alpha$ = 1,253 keV) als Quelle. Zunächst wurden von den Probenstücken Übersichtsspektren (Bereich 0 - 1400 eV) aufgenommen. Aus den Übersichtsspektren wurde auf die an der untersuchten Oberseite der Probenstücke enthaltenen Elemente geschlossen. Anschließend wurden von den Probenstücken in den Energiebereichen, in denen Signale im Übersichtsspektrum identifiziert werden konnten, Detailspektren aufgenommen. Für die Aufnahme der Detailspektren wurde ein Röntgenstrahl (200 $\mu$m Durchmesser; 50 W bei 15 kV; Messzeit: 25 - 40 min (zum Beispiel: 30 min); 20 ms Integrationszeit pro Messpunkt) bei aktivierter Peak-To-Noise-Einstellung und unter Verwendung eines Neutralisators (Kombination aus Ar+ und e-, bei geringer kinetischer Energie) eingesetzt. Die Auswertung der Spektren erfolgte mit der Analysesoftware CasaXPS (Version 5 2.3.224PR1.0; Casa Software Ltd.). Die C-C/C-H-Komponente des C 1s-Signals (ubiquitär vorhanden) wurde als Referenz auf den Wert 284,8 eV normiert und die Bindungsenergien der Detailspektren wurden entsprechend verschoben. Zur Untergrundkorrektur wurde eine ShirleyFunktion verwendet. Aus den erhaltenen Signalen wurden mittels der Analysesoftware Peaks generiert. Die Anzahl an Peaks wurde basierend auf Fitmodellen aus der Literatur (XPS-NIST10 Datenbank) angepasst und die Peaks wurden Elementen bzw. Verbindungen zugeordnet. Mit der Analysesoftware wurden für die generierten Peaks die Peakflächen unter Berücksichtigung der Relativen Empfindlichkeitsfaktoren berechnet.

Zusammensetzung der Haftvermittlungsschicht

Die Zusammensetzung der Haftvermittlungsschicht wird durch eine energiedispersive Röntgenspektroskopie (EDX), gekoppelt mit Rasterelektronenmikroskopie, bestimmt (REM-EDX).

Bei REM-EDX wird ein fokussierter Primär-Elektronenstrahl punktweise über die Probenoberfläche geführt (gerastert). Die gestreuten Elektronen werden mit einem Detektor erfasst, wobei die Elektronenzahl pro Bildpunkt ein mikroskopisches Abbild der Probenoberfläche in Graustufen ergibt. Zusätzlich regt der Primär-Elektronenstrahl die Probe zur Emission von charakteristischer Röntgenstrahlung an, wobei die Elemente in der Probe und deren Gewichtsanteil durch die Analyse des Energiespektrums mit einem EDX-Detektor bestimmt werden kann. Für die Untersuchung wird beispielsweise ein RasterElektronenmikroskop (JSM-6060 SEM, JEOL Ltd) mit einem Silizium Drift EDX Detektor (NORAN, Thermo Scientific Inc) und einer Analysesoftware (Pathfinder Mountaineer EDS System, zum Beispiel Version 2.8, Thermo Scientific Inc) verwendet. Für die RasterElektronenmikroskopie werden folgende Einstellungen verwendet: Vergrößerung: 1000fach, Beschleunigungsspannung = 15 kV, Arbeitsabstand = 10 mm, Spotgröße (50 - 60) (eingestellt, um 25% +/- 5% der Totzeit des EDX-Detektors zu erreichen). Das EDX-Spektrum wurde unter Verwendung der folgenden Einstellungen des EDX-Detektors erfasst: Live Time = 30 s, Rate = auto, Low Energy Cutoff = 100 keV, High Energy Cutoff = Auto (per REM-Beschleunigungsspannung).

Durch REM-EDX lässt sich die Zusammensetzung der Haftvermittlungsschicht sowohl in qualitativer Hinsicht (Detektion bestimmter Elemente und Phasen, z.B. eine in der Haftvermittlungsschicht vorliegende Metallnitridphase) als auch quantitativ bestimmen. Die Messung wird beispielsweise an mindestens 10 Stellen der Haftvermittlungsschicht durchgeführt.

**Beispiele**

Aus einem Siliziumnitrid-Ausgangssubstrat, das Sollbruchstellen für eine Vereinzelung aufwies, wurden vier Siliziumnitrid-Einzelsubstrate (S1, S2, S3 und S4) abgetrennt. Die Keramiksubstrate S1-S4 wiesen übereinstimmende Abmessungen (174 mm x 139 mm x 0,32 mm) auf.

Keramiksubstrat S1 wurde in Vergleichsbeispiel 1 verwendet, Keramiksubstrat S2 wurde im erfindungsgemäßen Beispiel 1 verwendet und Keramiksubstrat S3 wurde im erfindungsgemäßen Beispiel 3 verwendet.

Für jedes der Siliziumnitrid-Einzelsubstrate S1-S3 wurde in dem Bereich der Vorderseite, der später nach der erfolgten Metallisierung wieder freigelegt wird, das Si2p-Signal im XPS-Spektrum gemessen. Auch in Substrat S4 wurde in dem entsprechenden Bereich auf der Keramikoberfläche das XPS-Si2p-Signal gemessen.

In jedem dieser Substrate S1-S4 zeigte das Si2p-Signal im XPS-Spektrum nur einen Peak. Die Maxima dieser Peaks stimmten im Wesentlichen miteinander überein und lagen bei 101,8 +/-0,1 eV.

Die Siliziumnitridsubstrate wurden durch identische Aktivlotverfahren unter den nachfolgend beschriebenen Bedingungen metallisiert.

Auf einer der Seiten des Keramiksubstrats wurde auf einer Fläche der Abmessung 168 mm x 130 mm eine Aktivlotpaste durch Siebdruck aufgebracht und für 15 Minuten bei 125°C vorgetrocknet. Die Aktivlotpaste bestand aus 67 Gewichtsprozent Kupferpulver, 19,8 Gewichtsprozent Zinnpulver und 3,7 Gewichtsprozent Titanhydrid und 9,5 Gewichtsprozent eines organischen Vehikels. Die Pastendicke nach der Vortrocknung betrug 25 +/- 5 $\mu$m. Anschließend wurde eine Kupferfolie aus sauerstofffreiem, hochleitfähigem Kupfer mit einer Reinheit von 99,99% und einer Abmessung von 170 mm x 132 mm x 0.3 mm auf die vorgetrocknete Paste gelegt. Danach wurde die so erzeugte Anordnung herumgedreht, die Paste gleichermaßen auf die gegenüberliegende Seite des Keramiksubstrats durch Siebdruck aufgebracht, vorgetrocknet und mit einer Kupferfolie bestückt, um eine Sandwichanordnung zu erhalten. Die Sandwichanordnung wurde mit einem Gewicht von 1 kg beschwert, bei einer Höchsttemperatur von 910°C für 20 Minuten gebrannt und anschließend auf Raumtemperatur abgekühlt, um einen unstrukturierten Metall-Keramik-Verbund zu erhalten. Aufgrund der Herstellung durch ein Aktivlöten liegt zwischen der Metallbeschichtung und dem Keramiksubstrat eine haftvermittelnde Reaktionsschicht vor. Diese enthält Titan (z.B. in Form eines Nitrids).

Jeder der drei Metall-Keramik-Verbunde wurde einer ersten Strukturierung unter Verwendung einer $CuCl_2$-haltigen Ätzlösung unterzogen. Dabei wurde auf der Vorderseite des Keramiksubstrats die Metallbeschichtung in den geätzten Bereichen abgetragen. Die aus dem Aktivlotverfahren resultierende Reaktionsschicht wurde allerdings durch die $CuCl_2$-haltige Ätzlösung nicht entfernt.

In Vergleichsbeispiel VB1 wurde die freigelegte Reaktionsschicht mit einer Ätzlösung, die Ammoniumfluorid, Fluorborsäure sowie Wasserstoffperoxid enthielt, entfernt.

In den erfindungsgemäßen Beispielen EB1 und EB2 wurde die freigelegte Reaktionsschicht durch eine Behandlung mit einem Ultrakurzpulslaser entfernt. Die Laserpulse wiesen eine Energiedichte von 2 J/cm$^2$ und 4 J/cm$^2$ auf und die Pulsfrequenz betrug 1000 kHz.

An den freigelegten Keramikoberflächen der erfindungsgemäßen Beispiele EB1-EB2 und des Vergleichsbeispiels VB1 wurden XPS-Spektren aufgenommen und die Benetzungswinkel mit Wasser bestimmt.

Die Bestimmung des Benetzungswinkels wurde an dem OCA 15EC Kontaktwinkelmessgerät von Dataphysics durchgeführt. Für die Bestimmung wurden drei Testflüssigkeiten, destilliertes Wasser, $CH_2I_2$ (Diiodmethan) und $C_2H_4$ $(OH)_2$ wasserfreie Ethylenglycol verwendet. Für jede Flüssigkeit wurden Kontaktwinkel and mindesten 20 Tropfen gemessen, um anschließend einen Mittelwert zu ermitteln.

Die XPS-Spektren wurden hinsichtlich des Si2p-Signals ausgewertet.

Die Ergebnisse sind in der nachfolgenden Tabelle 1 zusammengefasst.

Tabelle 1: XPS-Si2p-Signale der Siliziumnitridoberfläche und Benetzungswinkel mit Wasser

| Beispiel | Si2p-Signal | | | Benetzungswinkel mit Wasser |
|---|---|---|---|---|
| | 98,0-100,0 eV | 101,0-102,2 eV | 102,5-103,5 eV | |
| Ausgangssubstrat | Kein Peak | 1 Peak vorhanden | Kein Peak | n.b. |
| VB1 | Kein Peak | 1 Peak vorhanden | Kein Peak | 45° |
| EB1 | 1 Peak vorhanden | 1 Peak vorhanden | 1 Peak vorhanden | 61° |
| EB2 | 1 Peak vorhanden | 1 Peak vorhanden | 1 Peak vorhanden | 69° |

Durch die Behandlung mit dem gepulsten Laser wurden die Siliziumnitridsubstrate in ihrer Struktur modifiziert und zeigen daher im Vergleich zu dem Ausgangssubstrat und dem durch Ätzen freigelegten Substrat ein signifikant unterschiedliches Si2p-Signal.

Die Siliziumnitridoberflächen, die das erfindungsgemäße Si2p-Signal aufweisen, zeigen im Vergleich zur Oberfläche des Siliziumnitridausgangssubstrats und des durch Ätzen freigelegten Siliziumnitridsubstrats einen deutlich höheren Wasserbenetzungswinkel. Dies führt zu einem besseren Feuchtigkeitsschutz der Siliziumnitridkeramik.

**Patentansprüche**

1. Ein Metall-Keramik-Verbund, enthaltend

ein Keramiksubstrat, das eine Vorderseite und eine Rückseite aufweist und Siliziumnitrid enthält,
eine auf der Vorderseite des Keramiksubstrats vorliegende Metallbeschichtung,
wobei
die Metallbeschichtung zumindest eine Aussparung aufweist und eine Oberfläche des Keramiksubstrats durch die Aussparung freigelegt ist,
das Keramiksubstrat zumindest in dem Bereich der Aussparung in einem durch Röntgenphotoelektronenspektroskopie aufgenommen Energiespektrum im Bereich von 96 bis 107 eV ein Si2p-Signal zeigt,
wobei das Si2p-Signal Folgendes aufweist:

einen oder mehrere Peaks, die jeweils ein Maximum im Bereich von 98,0 bis 100,0 eV aufweisen,
einen oder mehrere Peaks, die jeweils ein Maximum im Bereich von 101,0 bis 102,2 eV aufweisen,
einen oder mehrere Peaks, die jeweils ein Maximum im Bereich von 102,5 bis 104,0 eV aufweisen.

2. Der Metall-Keramik-Verbund nach Anspruch 1, wobei folgende Beziehungen erfüllt sind:

$$I_1 / I_{ges} \geq 0{,}02;$$

$$2{,}0 \leq I_2 / I_1 \leq 8{,}0; \text{ unter der Maßgabe, dass } (I_1 + I_2) / I_{ges} \leq 0{,}85;$$

$$(I_1 + I_2 + I_3) / I_{ges} \geq 0{,}95;$$

wobei

$I_{ges}$ die Gesamtintensität des Si2p-Signals ist;
$I_1$ die Gesamtintensität der Peaks ist, deren Maximum jeweils im Bereich von 98,0-100,0 eV liegt;
$I_2$ die Gesamtintensität der Peaks ist, deren Maximum jeweils im Bereich von 101,0-102,2 eV liegt;

I$_3$ die Gesamtintensität der Peaks ist, deren Maximum jeweils im Bereich von 102,5-104,0 eV liegt.

3.  Der Metall-Keramik-Verbund nach Anspruch 1 oder 2, wobei in den Bereichen von 98,0 bis 100,0 eV, 101,0 bis 102,2 eV und 102,5 bis 104,0 eV jeweils nicht mehr als zwei Peaks vorliegen, deren Maxima in dem jeweiligen Bereich liegen.

4.  Der Metall-Keramik-Verbund nach einem der vorstehenden Ansprüche, wobei das Keramiksubstrat das Siliziumnitrid in einem Anteil von mindestens 70 Gew% enthält.

5.  Der Metall-Keramik-Verbund nach einem der vorstehenden Ansprüche, wobei die Metallbeschichtung eine Kupfer- oder Aluminiumbeschichtung ist.

6.  Der Metall-Keramikverbund nach einem der vorstehenden Ansprüche, wobei zwischen dem Keramiksubstrat und der Metallbeschichtung eine Reaktionsschicht vorliegt, wobei die Reaktionsschicht ein oder mehrere Elemente E$_{RS}$, ausgewählt aus Ti, Hf, Zr, Nb, V, Ta und Ce, enthält.

7.  Ein Halbleitermodul, enthaltend

    den Metall-Keramik-Verbund gemäß einem der Ansprüche 1-6,
    ein oder mehrere Halbleiterbauelemente.

8.  Das Halbleitermodul nach Anspruch 7, außerdem enthaltend:
    eine Vergussmasse, wobei die Vergussmasse die durch die Aussparung freigelegte Oberfläche des Keramiksubstrats des Metall-Keramik-Verbunds kontaktiert.

Europäisches
Patentamt

European
Patent Office

Office européen
des brevets

**EUROPÄISCHER RECHERCHENBERICHT**

Nummer der Anmeldung

EP 23 21 3376

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2019 135099 A1 (ROGERS GERMANY GMBH [DE]) 24. Juni 2021 (2021-06-24) * Absätze [0013], [0018], [0025] - [0027], [0039], [0042] * * Abbildungen 1-3 * | 1-8 | INV. C04B37/02 C04B41/53 H01L21/306 C04B41/00 |
| X | EP 3 599 636 B1 (BOSCH GMBH ROBERT [DE]) 14. September 2022 (2022-09-14) * Absätze [0014], [0025] - [0028]; Abbildungen 1,2 * | 1-8 | |
| X | CN 111 704 479 A (OPPO GUANGDONG MOBILE TELECOMMUNICATIONS CO LTD) 25. September 2020 (2020-09-25) * Absätze [0017], [0024] - [0026], [0035], [0053] - [0059] * * Anspruch 9 * | 1-8 | |
| X | US 2019/385926 A1 (NABA TAKAYUKI [JP] ET AL) 19. Dezember 2019 (2019-12-19) * Absätze [0077] - [0087] * | 1-8 | RECHERCHIERTE SACHGEBIETE (IPC) |
| A | US 2010/032143 A1 (DATTA MADHAV [US] ET AL) 11. Februar 2010 (2010-02-11) * Absätze [0050] - [0051]; Anspruch 6; Abbildungen 9-11 * | 1-8 | C04B H01L |
| A | CN 117 043 934 A (ROGERS GERMANY GMBH) 10. November 2023 (2023-11-10) * Ansprüche 4-5 * | 1-8 | |

Der vorliegende Recherchenbericht wurde für alle Patentansprüche erstellt

| Recherchenort | Abschlußdatum der Recherche | Prüfer |
|---|---|---|
| Den Haag | 16. Mai 2024 | Sow, Eve |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 23 21 3376

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-05-2024

| Im Recherchenbericht angeführtes Patentdokument | Datum der Veröffentlichung | Mitglied(er) der Patentfamilie | Datum der Veröffentlichung |
|---|---|---|---|
| DE 102019135099 A1 | 24-06-2021 | DE 102019135099 A1 | 24-06-2021 |
| | | EP 4021869 A1 | 06-07-2022 |
| | | JP 7400109 B2 | 18-12-2023 |
| | | JP 2023506558 A | 16-02-2023 |
| | | WO 2021122035 A1 | 24-06-2021 |
| EP 3599636 B1 | 14-09-2022 | DE 102018212272 A1 | 30-01-2020 |
| | | EP 3599636 A1 | 29-01-2020 |
| CN 111704479 A | 25-09-2020 | KEINE | |
| US 2019385926 A1 | 19-12-2019 | CN 110313064 A | 08-10-2019 |
| | | EP 3608951 A1 | 12-02-2020 |
| | | JP 7204637 B2 | 16-01-2023 |
| | | JP 7451638 B2 | 18-03-2024 |
| | | JP 2022177207 A | 30-11-2022 |
| | | JP WO2018173921 A1 | 30-01-2020 |
| | | US 2019385926 A1 | 19-12-2019 |
| | | US 2023154826 A1 | 18-05-2023 |
| | | WO 2018173921 A1 | 27-09-2018 |
| US 2010032143 A1 | 11-02-2010 | CN 102171378 A | 31-08-2011 |
| | | CN 102171897 A | 31-08-2011 |
| | | US 2010032143 A1 | 11-02-2010 |
| | | US 2010035024 A1 | 11-02-2010 |
| | | WO 2010017321 A1 | 11-02-2010 |
| | | WO 2010017327 A1 | 11-02-2010 |
| CN 117043934 A | 10-11-2023 | CN 117043934 A | 10-11-2023 |
| | | DE 102021107690 A1 | 29-09-2022 |
| | | EP 4315418 A1 | 07-02-2024 |
| | | JP 2024510808 A | 11-03-2024 |
| | | KR 20230150354 A | 30-10-2023 |
| | | WO 2022200406 A1 | 29-09-2022 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **N. CHASSERIO et al.** Ceramic Substrates for High-Temperature Electronic Integration. *Journal of Electronic Materials*, 2009, vol. 38, 164-174
- **K. HIRAO et al.** High Thermal Conductivity Silicon Nitride Ceramics. *Journal of the Korean Ceramic Society*, 2012, vol. 49, 380-384
- **Y. ZHOU et al.** Development of high-thermal-conductivity silicon nitride ceramics. *Journal of Asian Ceramic Societies*, 2015, vol. 3, 221-229
- Aktivlöten. Brevier Technische Keramik, Verband der Keramischen Industrie e.V.. Fahner Verlag, 2003, 203-204
- **A. PÖNICKE et al.** Aktivlöten von Kupfer mit Aluminiumnitrid- und Siliziumnitridkeramik. *Keramische Zeitschrift*, 2011, vol. 63 (5), 334-342